# EUROPEAN PATENT APPLICATION

(11) **EP 4 797 909 A1**
(43) Date of publication of application: **26.08.2026**
(21) Application number: 25880943.3
(22) Date of filing: 26.11.2025
(51) Int. Cl.: H10F 19/80

(54) **BACK CONTACT SOLAR CELL MODULE AND SYSTEM**

(30) Priority: 31.12.2024 CN 202423322585 U
(71) Applicant: Zhuhai Fushan Aiko Solar Technology Co., Ltd., Zhuhai, Guangdong 519175 (CN); Zhejiang Aiko Solar Technology Co., Ltd, Jinhua, Zhejiang 322009 (CN); Guangdong Aiko Solar Technology Co., Ltd, Foshan, Guangdong 528137 (CN); Tianjin Aiko Solar Technology Co., Ltd, Tianjin 300400 (CN); Shandong Aiko Solar Technology Co., Ltd, Jinan, Shandong 250000 (CN); Chuzhou Aiko Solar Technology Co., Ltd., Chuzhou, Anhui 239514 (CN); Shenzhen Aiko Digital Energy Engineering Co., Ltd, Shenzhen, Guangdong 518048 (CN)
(72) Inventor: PENG, Qingqing, Jinhua, Zhejiang 322009 (CN); XU, Yehai, Jinhua, Zhejiang 322009 (CN); DENG, Zhongguo, Jinhua, Zhejiang 322009 (CN); CHEN, Gang, Jinhua, Zhejiang 322009 (CN)
(74) Representative: EP&C
(86) International application number: PCT/CN2025/137921
(87) International publication number: WO 2026/144687

(57) **Abstract**

The present application discloses a back-contact cell assembly and a system. The back-contact cell assembly includes: a cell string, where the cell string includes at least a first cell and a second cell sequentially arranged along a first direction, and the first cell is disposed at an end portion of the cell string; a first solder ribbon disposed on a back side of the first cell; a second solder ribbon disposed on a back side of the second cell; and a first busbar disposed on the back side of the second cell.

## Description

### Cross-Reference to Related Application

The present application claims the priority to Chinese Patent Application No. 202423322585.7, filed with the China National Intellectual Property Administration on December 31, 2024 and entitled "Back-Contact Cell Assembly and Photovoltaic System", which is incorporated herein by reference in its entirety.

### Technical Field

The present application belongs to the field of photovoltaic technologies, and in particular, to a back-contact cell assembly and a photovoltaic system.

### Background

In the existing back-contact cell assemblies, series busbars connecting adjacent cell strings in series are typically placed at an edge of the cell assembly, and parallel busbars connecting adjacent cell strings in parallel are typically placed in a reserved gap between two cell strings. This design requires a certain amount of space at the edge of the cell assembly for placing the series busbars, and a reserved space between two parallel-connected cell strings for placing the parallel busbars. However, this design not only reduces an effective light-receiving area of the cell assembly and thus lowers the conversion efficiency of the assembly, but also affects the aesthetic appearance of the assembly.

In some products, a busbar is installed at a middle position on a back side of a cell, and an insulating strip is arranged between the busbar and the cell. Although such an arrangement can conceal the busbar, perforation processing is required on the insulating strip, such that the busbar can contact a same-polarity solder ribbon on the cell and is insulated from an opposite-polarity solder ribbon on the cell. Such an arrangement imposes relatively high requirements on the perforation precision of the insulating strip and the arrangement position precision of the insulating strip, results in high production difficulty, and is likely to cause short circuit or poor soldering due to position deviation occurring during the perforation processing of the insulating strip.

### Summary

The present application provides a back-contact cell assembly, which aims to solve a problem in which an existing insulating strip requires perforation processing, the perforation precision of the insulating strip and the arrangement position precision of the insulating strip are required to be relatively high, the production difficulty is high, and short circuit or poor soldering is easily caused due to position deviation occurring during the perforation processing of the insulating strip.

The present application is implemented as follows. A back-contact cell assembly includes: a cell string, where the cell string includes at least a first cell and a second cell sequentially arranged along a first direction, and the first cell is disposed at an end portion of the cell string; a first solder ribbon, where the first solder ribbon is disposed on a back side of the first cell; a second solder ribbon, where the second solder ribbon is disposed on a back side of the second cell; a first busbar, where the first busbar is disposed on the back side of the second cell; and a first insulating strip, where the first insulating strip is disposed between the first busbar and the second cell, the first insulating strip is configured to isolate the second solder ribbon from the first busbar, the first insulating strip and the first busbar both extend along a second direction, and the first direction intersects the second direction; the first solder ribbon includes a main section electrically connected to the first cell and an extension section electrically connected to the first busbar, the extension section and the second solder ribbon are spaced apart along the second direction, and the main section and the second solder ribbon are arranged collinearly along the first direction.

In some embodiments, the first solder ribbon further includes a connection section, and the connection section is connected between the main section and the extension section.

In some embodiments, the back-contact cell assembly satisfies at least one of the following: the main section and the connection section are smoothly transitioned; or the extension section and the connection section are smoothly transitioned.

In some embodiments, the connection section is bent relative to the main section along the second direction.

In some embodiments, the back-contact cell assembly satisfies one of the following: a plurality of first solder ribbons are provided, and connection sections of the plurality of first solder ribbons are bent toward a first side of the main section along the second direction; connection sections of the plurality of first solder ribbons are bent toward a second side of the main section along the second direction; one portion of the connection sections of the plurality of first solder ribbons are bent toward the first side of the main section, another portion of the connection sections of the plurality of first solder ribbons are bent toward the second side of the main section, and the first side is opposite to the second side.

In some embodiments, a bending angle of the connection section relative to the main section is greater than or equal to 10° and less than or equal to 70°.

In some embodiments, a bending angle of the connection section relative to the main section is greater than or equal to 30° and less than or equal to 60°.

In some embodiments, the extension section and the second solder ribbon are arranged in parallel.

In some embodiments, a spacing distance between the extension section and the second solder ribbon satisfies: 1 mm ≤ L1 ≤ 1/2D, where L1 is a spacing distance between the extension section and the second solder ribbon along the second direction, and D is a spacing between two adjacent second solder ribbons.

In some embodiments, an extension direction of the extension section intersects an extension direction of the second solder ribbon.

In some embodiments, a minimum spacing distance between the extension section and the second solder ribbon satisfies: 1 mm ≤ L2 ≤ 1/2D, where L2 is a minimum spacing distance between the extension section and the second solder ribbon along the second direction, and D is a spacing between two adjacent second solder ribbons.

In some embodiments, the first cell and the second cell are disposed on a same plane, and the first cell and the second cell are spaced apart.

In some embodiments, a spacing distance between the first cell and the second cell is greater than or equal to 0 and less than or equal to 3 mm.

In some embodiments, the first cell and the second cell are partially overlapped along the first direction.

In some embodiments, a partial overlapping distance between the first cell and the second cell is greater than 0 and less than or equal to 1.5 mm.

In some embodiments, the back-contact cell assembly further includes a third solder ribbon, the third solder ribbon extends from the first cell to the second cell along the first direction, and the third solder ribbon is connected to the first cell and the second cell.

In some embodiments, a plurality of third solder ribbons are provided, and at least one first solder ribbon and at least one second solder ribbon are disposed between two adjacent third solder ribbons.

In some embodiments, a first soldering point is disposed at one end of the first cell close to the second cell, and the first soldering point is connected to the first solder ribbon.

In some embodiments, the first busbar is disposed at an end portion of the second cell close to the first cell.

In some embodiments, the back-contact cell assembly includes at least two groups of cell strings arranged along the second direction, and the first insulating strip extends from one group of cell strings to another group of cell strings among the two groups of cell strings along the second direction.

According to the present application, the first busbar can be concealed on a back side of a cell, so that an effective light-receiving area of a cell assembly is increased, the conversion efficiency of the cell assembly is improved, and the overall aesthetic appearance of the cell assembly is improved. In addition, the first busbar is disposed on the second cell, so that the first solder ribbon can be fully attached to and soldered at an effective soldering position of the first cell, insufficient soldering between the first solder ribbon and the first cell caused by the arrangement of the first busbar is avoided, and current collection is not affected. The first insulating strip is disposed between the second cell and the first busbar for isolation during assembly, so that the perforation processing and discontinuous arrangement are not required for the first insulating strip, and the processing and installation procedures of the first insulating strip are greatly simplified. Meanwhile, the first solder ribbon is provided with an extension section electrically connected to the first busbar, and the extension section and the second solder ribbon are spaced apart along the second direction, so that the first insulating strip is allowed a positional deviation along the first direction during the preparation process, which effectively reduces production precision requirements and production difficulty, and lowers a risk of short circuit. Due to the offset arrangement of the extension section and the second solder ribbon, the stacking height is reduced, the stress during lamination is reduced, the risks of microcracks and fragments of a cell are reduced, and the reliability of the back-contact cell assembly is improved.

A photovoltaic system includes the back-contact cell assembly described above. The technical effects of the photovoltaic system are the same as those of the back-contact cell assembly described above. Details are not described herein again.

### Brief Description of Drawings

FIG. 1 is a schematic diagram of a first back-contact cell assembly according to the present application;
FIG. 2 is a schematic diagram of a second back-contact cell assembly according to the present application;
FIG. 3 is an enlarged schematic diagram of a structure at position A in FIG. 2;
FIG. 4 is a cross-sectional diagram of a first back-contact cell assembly according to the present application;
FIG. 5 is a cross-sectional diagram of a second back-contact cell assembly according to the present application; and
FIG. 6 is a schematic diagram of a third back-contact cell assembly according to the present application.

### Description of reference numerals:

100. cell string; 101. first cell; 102. second cell; 200. first solder ribbon; 201. main section; 202. extension section; 203. connection section; 300. second solder ribbon; 400. first busbar; 500. first insulating strip; 600. third solder ribbon; and 700. first soldering point.

### Detailed Description of Embodiments

To make the object, technical solutions, and advantages of the present application clearer, the present application will be further described in detail with reference to the accompanying drawings and embodiments. The examples of embodiments are shown in the accompanying drawings, where the same or similar labels throughout represent the same or similar elements or the elements with the same or similar functions. Embodiments described below with reference to the accompanying drawings are exemplary, and are only intended to explain the present application and cannot be understood as limiting the present application. In addition, it should be understood that the specific embodiments described here are intended for illustrating rather than limiting the present application.

In the description of the present application, it should be understood that, the terms "length", "width", "up", "down", "left", "right", "horizontal", "top", and "bottom" indicate the orientation or position relationship based on the orientation or position relationship shown in the accompanying drawings, only for the convenience of simple description of the present application, rather than indicating or implying that the devices or elements referred to must have a specific orientation, be constructed and operated in a specific orientation, and therefore cannot be understood as a limitation on the present application.

In addition, the terms "first" and "second" are used solely for descriptive purposes and cannot be understood as indicating or implying relative importance or as implicitly specifying the quantity of the indicated technical features. Therefore, the features denoted as "first" and "second" can explicitly or implicitly include one or more features. In the description of the present application, the term "a plurality of" means two or more, unless otherwise specifically and explicitly defined.

In the description of the present application, it should be noted that unless otherwise specified and limited, the terms "installation", "connected", and "connection" should be broadly understood, for example, they may be fixed connection, detachable connection, or integrated connection, and may be mechanical connection, also be electrical connection, or mutual communication, direct connection or indirect connection through an intermediate medium, and may also be the internal connection or interaction relationship between two components. For those of ordinary skill in the art, the specific meanings of the above terms in the present application can be understood according to the specific circumstances.

In the present application, unless otherwise specified and limited, the first feature "above" or "below" the second feature may include direct contact between the first and second features, or direct contact between the first and second features through additional features therebetween. Moreover, the first feature "over", "above" and "on" the second feature includes the first feature being directly above and diagonally above the second feature, or simply indicates that the first feature is horizontally higher than the second feature. The first feature "below", "beneath", and "under" the second feature includes the first feature directly below and diagonally below the second feature, or simply indicates that the horizontal height of the first feature is less than that of the second feature.

The following disclosure provides a plurality of different embodiments or examples for implementing various structures of the present application. For the purpose of simplifying the disclosure of the present application, components and arrangements of specific examples are described below. These examples are provided merely for illustration and are not intended to limit the present application. In addition, the present application may repeatedly use at least one of the reference numerals and reference letters in different examples. Such repetition is for the purpose of simplification and clarity and does not, by itself, indicate a relationship among at least one of the various embodiments and arrangements discussed. Furthermore, the present application provides examples of various specific processes and materials; however, those of ordinary skill in the art will recognize that at least one of other processes and other materials can be applied or used.

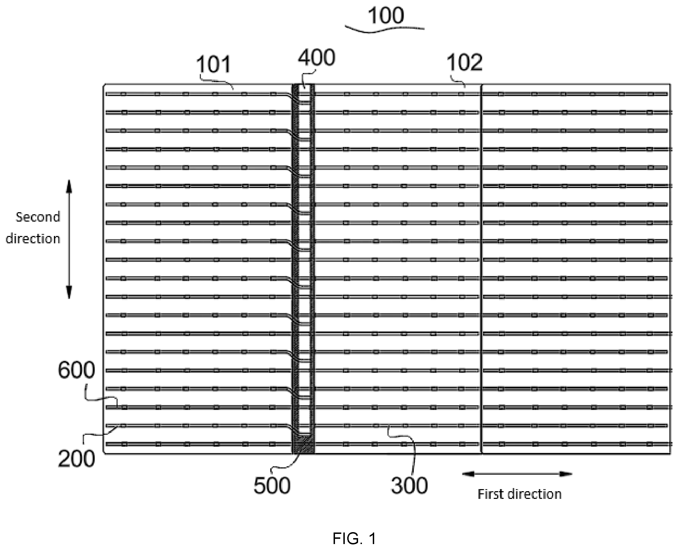

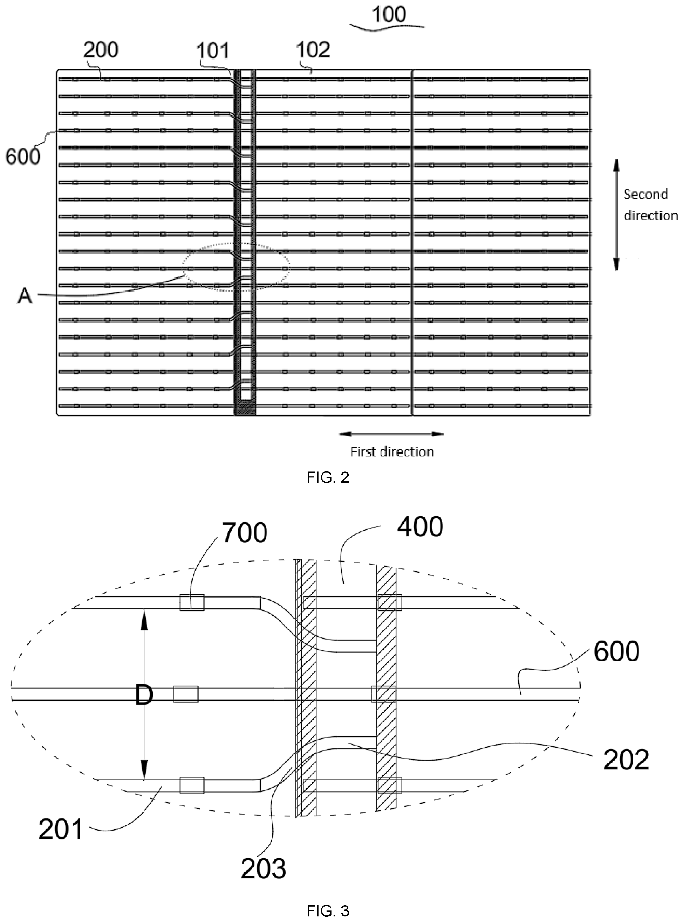

As shown in FIGS. 1 and 2, in an embodiment of the present application, a back-contact cell assembly includes a cell string 100, the cell string 100 includes at least a first cell 101 and a second cell 102 sequentially arranged along a first direction. It can be understood that the cell string 100 may include two cells connected in series, three cells connected in series, or any other greater number of cells, and the specific number of cells to be connected in series can be determined according to actual use. This is not limited herein. In addition, grid lines on the cells are not shown in the drawings. The grid lines on the cells can be arranged according to actual circumstances; for example, the cell may be a cell with a main grid or a cell without a main grid. It can be understood that when the cell is a cell with a main grid, a first main grid line is disposed at a position on the first cell 101 corresponding to the first solder ribbon 200, and a corresponding second main grid line is disposed at a position on the second cell 102 corresponding to the second solder ribbon 300; and when the cell is a cell without a main grid, corresponding soldering points can be disposed at a position on the first cell 101 corresponding to the first solder ribbon 200, and corresponding soldering points can be disposed at a position on the second cell 102 corresponding to the second solder ribbon 300.

The first cell 101 is disposed at an end portion of the cell string 100. For ease of description, in this embodiment, one end where the first cell 101 is located is referred to as a tail end of the cell string 100. That is, along the first direction, the first cell 101 is a last cell of the cell string 100, and the second cell 102 is a penultimate cell of the cell string 100. It is readily understood that one end where the first cell 101 is located can alternatively be referred to as a head end of the cell string 100, and the second cell 102 is the second cell of the cell string 100 in the forward direction. Details are not described herein again. It should be noted that when the first cell 101 is disposed at a tail end of the cell string 100, the first busbar 400 may be configured for series connection between adjacent cell strings 100 along the second direction; and when the first cell 101 is disposed at a head end of the cell string 100, the first busbar 400 may be configured for parallel connection between adjacent cell strings 100 along the first direction, and the first busbar 400 functions as an intermediate busbar within the cell assembly.

In some embodiments, the first solder ribbon 200 is disposed on a back side of the first cell 101, the second solder ribbon 300 is disposed on a back side of the second cell 102, the first busbar 400 is disposed on the back side of the second cell 102, and the first insulating strip 500 is disposed between the first busbar 400 and the second cell 102. The first insulating strip 500 is configured to isolate the second solder ribbon 300 from the first busbar 400. Both the first insulating strip 500 and the first busbar 400 extend along the second direction, and the first direction intersects the second direction. First, in this embodiment of the present application, the first busbar 400 is disposed on the second cell 102, and the first busbar 400 is separated from the second cell 102 by the first insulating strip 500. Therefore, in one aspect, the edge of the back-contact cell assembly is not required to reserve a space for placing the busbar, and more space is reserved for cell installation on the cell assembly, thereby increasing an effective light-receiving area of the cell assembly and improving the conversion efficiency of the cell assembly. In another aspect, from a perspective along a light-receiving surface (or "front side") of the cell, the first insulating strip 500 can conceal the first busbar 400, preventing the first busbar 400 from being exposed, which improves the overall aesthetic appearance of the cell assembly.

Second, in a possible configuration in which the first busbar 400 is disposed on a back side of the first cell 101, the first solder ribbon 200 cannot be soldered to the first cell 101 at a position where the first busbar 400 is concealed, resulting in insufficient soldering between the first solder ribbon 200 and the first cell 101 and poor current collection. In this embodiment of the present application, the first busbar 400 is disposed on the back side of the second cell 102, and the first solder ribbon 200 can be fully fitted and soldered to an effective soldering position of the first cell 101, thereby avoiding insufficient soldering between the first solder ribbon 200 and the first cell 101 caused by the installation of the first busbar 400, which would affect current collection. Meanwhile, after soldering to the first cell 101, the first solder ribbon 200 can be directly connected to the first busbar 400 without performing perforation on the insulating strip (a first insulating strip 500). During assembly, the first insulating strip 500 can simply be placed as a whole onto the second cell 102, so that the production precision requirements and production difficulty are effectively reduced, the risk of short circuit caused by position deviation during the perforation of the insulating strip (the first insulating strip 500) can be avoided, and thus the product yield is increased. Preferably, the first busbar 400 is disposed at an end portion of the second cell 102 close to the first cell 101, and the extension section 202 (as shown in FIG. 3) extends to an edge of the second cell 102 close to the first cell 101, thereby achieving electrical connection with the first busbar 400. This arrangement can reduce the extension length of the extension section 202 of the first solder ribbon 200, saving solder ribbon material and thus reducing costs. Since the first solder ribbon 200 needs to be isolated from the second cell 102, this arrangement also reduces the width requirement of the first insulating strip 500. The first insulating strip 500 only needs to provide insulation for the edge region of the second cell 102.

In this embodiment of the present application, the first direction is a horizontal direction, which also corresponds to a width direction of the cells, and the second direction is a vertical direction, which also corresponds to a length direction of the cells. The first direction is perpendicular to the second direction.

As shown in FIG. 3, in an embodiment of the present application, the first solder ribbon 200 includes a main section 201 electrically connected to the first cell 101 and an extension section 202 electrically connected to the first busbar 400. The extension section 202 and the second solder ribbon 300 are spaced apart along the second direction, and the main section 201 and the second solder ribbon 300 are arranged collinearly along the first direction. That is, the extension section 202 of the first solder ribbon 200 is offset relative to the main section 201 of the first solder ribbon 200, so that the extension section 202 extending onto the second cell 102 does not overlap with the second solder ribbon 300 on the second cell 102 in the thickness direction of the first busbar 400. This arrangement avoids excessive stress caused by partial overlap between the extension section 202 and the second solder ribbon 300 on the first busbar 400, and reduces the risk of microcracks in the cells during lamination. The collinear arrangement of the main section 201 and the second solder ribbon 300 along the first direction can simplify the solder ribbon routing and reduce routing difficulty and complexity.

It can be understood that, due to existing manufacturing processes (such as process errors), the main section 201 and the second solder ribbon 300 may not be geometrically perfectly collinear. For example, the main section 201 and the second solder ribbon 300 may be offset by within 1 mm along the length direction of the first busbar 400, or the main section 201 may be slightly inclined relative to the second solder ribbon 300 at a small angle (e.g., 0.5°), which can still be considered collinear. The electrical connection can be achieved by soldering, conductive adhesive bonding, or other suitable means, which is not limited thereto.

According to the present application, the first busbar can be concealed on a back side of a cell, so that an effective light-receiving area of a cell assembly is increased, the conversion efficiency of the cell assembly is improved, and the overall aesthetic appearance of the cell assembly is improved. In addition, the first busbar is disposed on the second cell, so that the first solder ribbon can be fully attached to and soldered at an effective soldering position of the first cell, insufficient soldering between the first solder ribbon and the first cell caused by the arrangement of the first busbar is avoided, and current collection is not affected. The first insulating strip is disposed between the second cell and the first busbar for isolation during assembly, so that the perforation and arrangement are not required for the first insulating strip, and the processing and installation procedures of the first insulating strip are greatly simplified. Meanwhile, the first solder ribbon is provided with an extension section electrically connected to the first busbar, and the extension section and the second solder ribbon are spaced apart along the second direction, so that the first insulating strip is allowed a positional deviation along the first direction during the preparation process, which effectively reduces production precision requirements and production difficulty, and lowers a risk of short circuit. Due to the offset arrangement of the extension section and the second solder ribbon, the stacking height is reduced, the stress during lamination is reduced, the risks of microcracks and fragments of a cell are reduced, and the reliability of the back-contact cell assembly is improved.

As shown in FIG. 3, further, the first solder ribbon 200 also includes a connection section 203, and the connection section 203 is connected between the main section 201 and the extension section 202. The connection section 203 is configured to achieve electrical conduction between the main section 201 and the extension section 202, so that the main section 201 can transmit carriers from the first cell 101 through the connection section 203 to the extension section 202, and further to the first busbar 400, thereby completing the collection of carriers on the first cell 101. Preferably, the back-contact cell assembly satisfies at least one of the following: the main section 201 and the connection section 203 are smoothly transitioned; and the extension section 202 and the connection section 203 are smoothly transitioned. More specifically, in this embodiment of the present application, the main section 201 and the connection section 203 are smoothly transitioned, and the extension section 202 and the connection section 203 are smoothly transitioned. The connection section 203 is bent relative to the main section 201, and the extension section 202 is bent relative to the connection section 203, so that the first solder ribbon 200 is continuously bent to form the connection section 203 and the extension section 202. The bends in the first solder ribbon 200 are prone to stress concentration, and the smooth transition design can effectively distribute such stress, so that the risk of fracture or detachment of the first solder ribbon 200 caused by stress concentration is reduced. The smoothly transitioned connecting portions also provide improved aesthetic appearance, so that the overall visual effect and quality perception of the product can be enhanced.

The first solder ribbon 200 having the main section 201, the connection section 203, and the extension section 202 can be formed as a single integral stamped ribbon or assembled by splicing a plurality of solder ribbons together. The present application is not limited thereto. Preferably, a morphological feature of the first solder ribbon 200 is a single integral stamped ribbon, such that redundant processes including soldering are omitted during fabrication of the first solder ribbon 200, the consumption of manpower is reduced, and the phenomena including poor soldering caused by manual soldering and burrs generated during soldering are avoided.

In this embodiment of the present application, the connection section 203 has a shape of a line segment or a bend. This is not specifically limited herein, as long as the extension section 202 and the second solder ribbon 300 can be spaced apart in the length direction of the first busbar 400. Preferably, the connection section 203 is a straight segment structure to avoid the reduction in strength caused by repeated bending of the solder ribbon, which could lead to fracture or detachment.

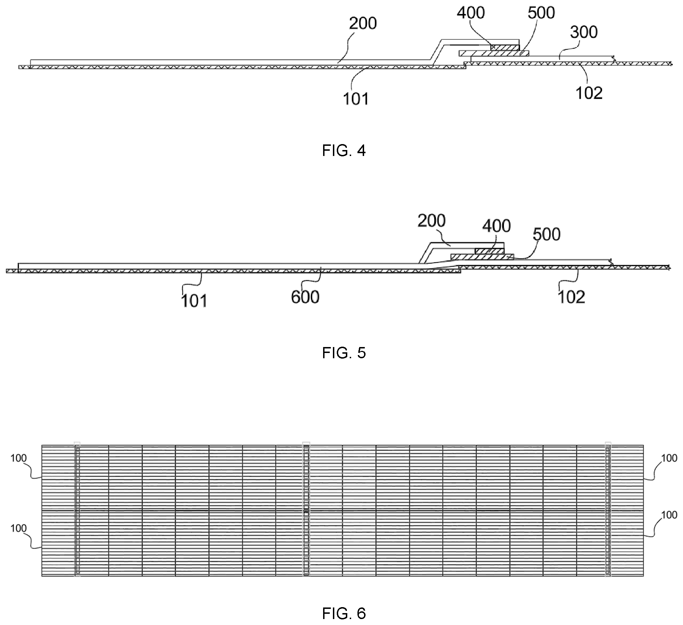

As shown in FIG. 4, in other embodiments, the first insulating strip 500 is disposed between the first busbar 400 and the second cell 102, and the first insulating strip 500 is configured to isolate the second solder ribbon 300 from the first busbar 400. Since the first solder ribbon 200 has a portion extending to the second cell 102, it can be understood that the first insulating strip 500 is also configured to isolate the first solder ribbon 200 from the second cell 102. Specifically, the first insulating strip 500 can be positioned at an end portion of the second cell 102 close to the first cell 101. Optionally, the first insulating strip 500 can cover the edges of both the second cell 102 and the first cell 101. In one aspect, a certain degree of positional deviation in a width direction is allowed during the preparation for the first insulating strip 500 relative to the first busbar 400 and for the first insulating strip 500 relative to the two cells, thereby reducing production precision requirements and production difficulty. In another aspect, the contact between the first busbar 400 and an opposite-polarity solder ribbon (or opposite-polarity grid line) on the first cell 101 is avoided to prevent a short circuit, contact between the first solder ribbon 200 and an opposite-polarity solder ribbon (or an opposite-polarity grid line) on the second cell 102 is avoided to prevent short circuit, and the short circuit caused by conductive foreign matters such as tin slag during the preparation is avoided, thereby further lowering a risk of short circuit and improving reliability of the cell assembly.

Correspondingly, in this embodiment of the present application, the first solder ribbon 200 is applicable to a back-contact cell assembly with a main grid and a back-contact cell assembly without a main grid, so that versatility is enhanced. Moreover, compared with a configuration in which the first busbar 400 is disposed at an outer edge of the first cell 101, the first busbar 400 disposed at an end portion of the second cell 102 close to the first cell 101 results in lower stress during lamination, reduced risk of fragmentation and cracking, and improved reliability of the cell assembly.

Exemplarily, a thickness of the first busbar 400 may range from 0.06 mm to 0.3 mm, and a width of the first busbar 400 may range from 8 mm to 20 mm. A material of the first busbar 400 includes a tin-plated copper busbar, a conductive copper foil, or an aluminum-based copper strip.

Exemplarily, the first insulating strip 500 may be an insulating adhesive, or is a non-conductive adhesive tape or an insulating film, for example, polyethylene terephthalate (PET) or polyimide (PI) tape containing acrylic adhesive or silicone adhesive, or polyethylene terephthalate (PET) or polyimide (PI) substrate coated on a single side or double sides with ethylene-vinyl acetate copolymer or hot melt adhesive. It can be understood that the first insulating strip 500 may include one of ethylene-vinyl acetate copolymer, resin material, polyimide, polypropylene, or polyethylene, and may further include an acrylic adhesive layer.

It should be noted that the thickness of the first insulating strip 500 should not be excessively large or excessively small. When the first insulating strip 500 is excessively thin, the pasting operation is inconvenient, the deformation is easily caused during pulling, and a risk of damage exists during long-term insulation. When the first insulating strip 500 is excessively thick, the height difference is increased, the stress generated during lamination is increased, the fragmentation is easily caused, and a risk of poor soldering is increased. Based on this, in this embodiment of the present application, the thickness of the first insulating strip 500 may range from 0.05 mm to 0.8 mm. In this way, the first insulating strip 500 is not excessively thin and is not excessively thick. For example, the thickness of the first insulating strip 500 is one of 0.05 mm, 0.1 mm, 0.2 mm, 0.3 mm, 0.4 mm, 0.5 mm, 0.6 mm, 0.7 mm, or 0.8 mm.

A width of the first insulating strip 500 is greater than or equal to a width of the first busbar 400. When the width of the first insulating strip 500 is excessively narrow, the first busbar 400 is exposed, and a risk of short circuit caused by contact between the first busbar 400 and an opposite-polarity electrode region or an opposite-polarity solder ribbon exists.

Further, a plurality of first solder ribbons 200 are provided, and the plurality of first solder ribbons 200 are spaced apart on the back side of the first cell 101 along the second direction. A plurality of second solder ribbons 300 are provided, and the plurality of second solder ribbons 300 are spaced apart on the back side of the second cell 102 along the second direction. The plurality of first solder ribbons 200 and the plurality of second solder ribbons 300 are disposed in one-to-one correspondence.

The connection section 203 is bent relative to the main section 201 along the second direction. Specifically, an included angle is formed between the main section 201 and the connection section 203 to define a bending direction of the connection section 203, so that the connection section 203 yields to the second solder ribbon 300 during bending. A magnitude of the included angle formed between the main section 201 and the connection section 203 is selected according to practical requirements. Details are not repeated herein.

Further, a bending angle of the connection section 203 relative to the main section 201 is greater than or equal to 10° and less than or equal to 70°. Preferably, the bending angle of the connection section 203 relative to the main section 201 is greater than or equal to 30° and less than or equal to 60°. In this embodiment, the bending angle of the connection section 203 relative to the main section 201 is any value between 30° and 60°. For example, the bending angle of the connection section 203 relative to the main section 201 is 30°, 40°, 50°, or 60°. This is not specifically limited herein. When the bending angle of the connection section 203 relative to the main section 201 falls within the above range, the strength of a metal material of the first solder ribbon 200 is not reduced due to excessive deformation, the precise processing is more easily achieved through mechanical equipment or automated equipment, and the first solder ribbon 200 is bent to form a required curvature by using relatively small force, thereby improving the production efficiency.

In this embodiment of the present application, the back-contact cell assembly satisfies at least one of the following: a plurality of first solder ribbons 200 are provided, and connection sections 203 of the plurality of first solder ribbons 200 are bent toward a first side of the main section 201 along the second direction; connection sections 203 of the plurality of first solder ribbons 200 are bent toward a second side of the main section 201 along the second direction; one portion of the connection sections 203 of the plurality of first solder ribbons 200 are bent toward the first side of the main section 201, another portion of the connection sections 203 of the plurality of first solder ribbons 200 are bent toward the second side of the main section 201, and the first side is opposite to the second side. That is, the connection sections 203 of the plurality of first solder ribbons 200 may be bent in the same direction or in different directions relative to the main section 201. A bending direction of the connection section 203 of the first solder ribbon 200 relative to the main section 201 of the first solder ribbon 200 can be selected according to practical requirements to accommodate different processing equipment and production workflows.

In some embodiments, the extension section 202 and the second solder ribbon 300 are arranged in parallel. This configuration ensures that the extension section 202 and the second solder ribbon 300 remain independent along the extension direction. Even when the extension section 202 has a relatively long length, the extension section 202 and the second solder ribbon 300 do not overlap in the thickness direction of the first busbar 400 and are distributed separately, which avoids localized stress concentration in the cell, thereby reducing a risk of microcracks. Preferably, a spacing distance between the extension section 202 and the second solder ribbon 300 satisfies 1 mm ≤ L1 ≤ 1/2D, where L1 is a spacing distance between the extension section 202 and the second solder ribbon 300 along the second direction, and D is a distance between two adjacent second solder ribbons 300. The spacing distance between the extension section 202 and the second solder ribbon 300 within this range fully ensures that the extension section 202 and the second solder ribbon 300 along the length direction of the first busbar 400 do not overlap, thereby achieving the effect of dispersing local stress in the cell assembly.

In some embodiments, an extension direction of the extension section 202 intersects an extension direction of the second solder ribbon 300. That is, the extension direction of the extension section 202 can be flexibly configured, which provides tolerance space during processing and installation of the first solder ribbon 200. The extension direction of the extension section 202 can be adjusted based on actual requirements to achieve a desired spacing between the extension section 202 and the second solder ribbon 300. Preferably, a minimum spacing distance between the extension section 202 and the second solder ribbon 300 satisfies: 1 mm ≤ L2 ≤ 1/2D, where L2 is a minimum spacing distance between the extension section 202 and the second solder ribbon 300 along the second direction, and D is a spacing between two adjacent second solder ribbons 300. The minimum spacing distance between the extension section 202 and the second solder ribbon 300 within this range fully ensures that the extension section 202 and the second solder ribbon 300 along the length direction of the first busbar 400 do not overlap, thereby achieving the effect of dispersing local stress in the cell assembly.

In some embodiments, the first cell 101 and the second cell 102 are disposed on a same plane, and the first cell 101 and the second cell 102 are spaced apart. This configuration provides a buffer space between the cells, and prevents the cells from contacting and being damaged under external force applied to the cell assembly.

Specifically, a spacing distance between the first cell 101 and the second cell 102 is greater than or equal to 0 mm and less than or equal to 3 mm. In this embodiment, the spacing distance between the first cell 101 and the second cell 102 can be any value between 0 mm and 3 mm. For example, the spacing distance between the first cell 101 and the second cell 102 may be 0 mm, 1 mm, 2 mm, or 3 mm. This is not specifically limited herein. Within this range, the risk of cell-to-cell contact is reduced, and the overall length of the cell string 100 is prevented from becoming excessive, thereby improving the stability of the connection between adjacent cells.

In some embodiments, the first cell 101 and the second cell 102 are partially overlapped along the first direction. A contact region formed by overlapping is not electrically connected, no conductive adhesive or other bonding adhesive is disposed in the overlapping region, and the cells are merely overlapped. In this way, there is no gap between the first cell 101 and the second cell 102, so that the series-connecting solder ribbons are better concealed, no shielding insulating layer is required to be disposed in the gap between the cells to hide the series-connecting solder ribbons, the usage of a shielding insulating layer is reduced, the production cost is lowered, and the rework is facilitated. In addition, through the overlapping arrangement between the cells, a size of the cell string 100 is reduced, so that the occupied space of the cell string 100 is reduced. Alternatively, when a size of the cell string 100 is constant, more cells are accommodated, so that the power of the cell string 100 is increased, and the cost per watt is reduced. Preferably, a partial overlapping distance between the first cell 101 and the second cell 102 is greater than 0 mm and less than or equal to 1.5 mm. Exemplarily, an overlapping width is one of 0 mm, 0.1 mm, 0.2 mm, 0.4 mm, 0.5 mm, 1 mm, or 1.5 mm. This is not limited herein.

As shown in FIG. 5, the back-contact cell assembly further includes a third solder ribbon 600, the third solder ribbon 600 extends from the first cell 101 to the second cell 102 along the first direction, and the third solder ribbon 600 is connected to the first cell 101 and the second cell 102. Specifically, one portion of the third solder ribbon 600 is disposed on the first cell 101, and another portion of the third solder ribbon 600 is disposed on the second cell 102. Exemplarily, the third solder ribbon 600 may be configured to achieve a series connection between the first cell 101 and the second cell 102. It can be understood that the extension section 202 and another portion of the third solder ribbon 600 disposed on the second cell 102 do not overlap. In a length direction of the first busbar 400, the extension section 202 of the first solder ribbon 200 and another portion of the third solder ribbon 600 disposed on the second cell 102 are spaced apart, thereby achieving an effect of local stress dispersion in the cell assembly. Further, the portion of the third solder ribbon 600 located on the second cell 102 is insulated from the first busbar 400 through the first insulating strip 500. In this embodiment of the present application, a plurality of third solder ribbons 600 are provided, and at least one first solder ribbon 200 and at least one second solder ribbon 300 are disposed between two adjacent third solder ribbons 600, so that current is uniformly distributed on the cells.

In some embodiments, a first soldering point 700 is disposed at one end of the first cell 101 close to the second cell 102, and the first soldering point 700 is connected to the first solder ribbon 200. It can be understood that the first soldering point 700 is located at an effective soldering position of the first cell 101 closest to an edge close to the second cell 102, (namely, a connection point of the first solder ribbon 200 at an outermost edge on the first cell 101). The first soldering point 700 may be a grid line or a pad, so as to achieve sufficient collection of carriers on the first cell and improve connection stability between the first solder ribbon 200 and the first cell 101.

As shown in FIG. 6, in some embodiments, the back-contact cell assembly includes at least two groups of cell strings 100 arranged along a second direction, and the first insulating strip 500 extends from one group of cell strings to another group of cell strings among the two groups of cell strings along the second direction. In this way, the laying of the first insulating strip 500 between at least two adjacent groups of cell strings can be completed at one time, so as to simplify assembly steps of a cell assembly and improve production efficiency of the cell assembly. It can be understood that the back-contact cell assembly includes a plurality of groups of cell strings, and the first insulating strip can be laid integrally across the plurality of groups of cell strings at one time. For example, when the back-contact cell assembly includes three groups of cell strings, the first insulating strip can extend from a first group of cell strings to a third group of cell strings.

A photovoltaic system includes the back-contact cell assembly described above. It can be understood that the photovoltaic system includes at least one back-contact cell assembly described above, and an electrical connection between back-contact cell assemblies may be implemented in a parallel connection manner or a series connection manner, which may be selectively configured based on actual requirements. In this embodiment, the photovoltaic system may be applied in photovoltaic power stations, such as ground-mounted power stations, rooftop power stations, and floating power stations, and can also be applied in devices or equipment utilizing solar energy for power generation, such as user solar power supplies, solar street lights, solar vehicles, and solar buildings. Of course, it can be understood that the application scenarios of the photovoltaic system are not limited to the foregoing. That is, the photovoltaic system can be applied in all fields requiring solar energy for power generation. Taking a photovoltaic power generation system grid as an example, the photovoltaic system can include a photovoltaic array, a combiner box, and an inverter. The photovoltaic array can be an array combination of a plurality of cell assemblies. For example, a plurality of cell assemblies can form a plurality of photovoltaic arrays. The photovoltaic arrays are connected to the combiner box, and the combiner box collects the currents generated by the photovoltaic arrays. The combined current then passes through the inverter to be converted into alternating current meeting the requirements of the utility grid, and is connected to the utility network to achieve a solar power supply.

In the description of the specification, the reference terms "some embodiments", "illustrative embodiments", "examples", "specific examples", or "some examples" refer to the specific features, structures, materials, or characteristics described in conjunction with embodiments or examples included in at least one embodiment or example of the present application. The schematic expressions of the above terms in the specification do not necessarily refer to the same embodiments or examples. Moreover, the specific features, structures, materials, or characteristics described can be combined in a suitable manner in any one or more embodiments or examples.

In addition, the above are only preferred embodiments of the present application and are not intended to limit the present application. Any modifications, equivalent substitutions, and improvements made within the spirit and principles of the present application shall be included in the scope of protection of the present application.

## Claims

1. A back-contact cell assembly, comprising: a cell string, wherein the cell string at least comprises a first cell and a second cell sequentially arranged along a first direction, and the first cell is disposed at an end portion of the cell string; a first solder ribbon, wherein the first solder ribbon is disposed on a back side of the first cell; a second solder ribbon, wherein the second solder ribbon is disposed on a back side of the second cell; a first busbar, wherein the first busbar is disposed on the back side of the second cell; and a first insulating strip, wherein the first insulating strip is disposed between the first busbar and the second cell, the first insulating strip is configured to isolate the second solder ribbon from the first busbar, the first insulating strip and the first busbar both extend along a second direction, and the first direction intersects the second direction; the first solder ribbon comprises a main section electrically connected to the first cell and an extension section electrically connected to the first busbar, the extension section and the second solder ribbon are spaced apart along the second direction, and the main section and the second solder ribbon are arranged collinearly along the first direction.

2. The back-contact cell assembly according to claim 1, wherein the first solder ribbon further comprises a connection section, and the connection section is connected between the main section and the extension section.

3. The back-contact cell assembly according to claim 2, wherein the back-contact cell assembly satisfies at least one of the following: the main section and the connection section are smoothly transitioned; or the extension section and the connection section are smoothly transitioned.

4. The back-contact cell assembly according to claim 2, wherein the connection section is bent relative to the main section along the second direction.

5. The back-contact cell assembly according to claim 4, wherein the back-contact cell assembly satisfies one of the following: a plurality of first solder ribbons are provided, and connection sections of the plurality of first solder ribbons are bent toward a first side of the main section along the second direction; connection sections of the plurality of first solder ribbons are bent toward a second side of the main section along the second direction; one portion of the connection sections of the plurality of first solder ribbons are bent toward the first side of the main section, another portion of the connection sections of the plurality of first solder ribbons are bent toward the second side of the main section, and the first side is opposite to the second side.

6. The back-contact cell assembly according to claim 4, wherein a bending angle of the connection section relative to the main section is greater than or equal to 10° and less than or equal to 70°.

7. The back-contact cell assembly according to claim 4, wherein a bending angle of the connection section relative to the main section is greater than or equal to 30° and less than or equal to 60°.

8. The back-contact cell assembly according to claim 1, wherein the extension section and the second solder ribbon are arranged in parallel.

9. The back-contact cell assembly according to claim 8, wherein a spacing distance between the extension section and the second solder ribbon satisfies: 1 mm ≤ L1 ≤ 1/2D, wherein L1 is a spacing distance between the extension section and the second solder ribbon along the second direction, and D is a spacing between two adjacent second solder ribbons.

10. The back-contact cell assembly according to claim 1, wherein an extension direction of the extension section intersects an extension direction of the second solder ribbon.

11. The back-contact cell assembly according to claim 10, wherein a minimum spacing distance between the extension section and the second solder ribbon satisfies: 1 mm ≤ L2 ≤ 1/2D, wherein L2 is a minimum spacing distance between the extension section and the second solder ribbon along the second direction, and D is a spacing between two adjacent second solder ribbons.

12. The back-contact cell assembly according to claim 1, wherein the first cell and the second cell are disposed on a same plane, and the first cell and the second cell are spaced apart.

13. The back-contact cell assembly according to claim 12, wherein a spacing distance between the first cell and the second cell is greater than or equal to 0 and less than or equal to 3 mm.

14. The back-contact cell assembly according to claim 1, wherein the first cell and the second cell are partially overlapped along the first direction.

15. The back-contact cell assembly according to claim 14, wherein a partial overlapping distance between the first cell and the second cell is greater than 0 and less than or equal to 1.5 mm.

16. The back-contact cell assembly according to claim 1, wherein the back-contact cell assembly further comprises a third solder ribbon, the third solder ribbon extends from the first cell to the second cell along the first direction, and the third solder ribbon is connected to the first cell and the second cell.

17. The back-contact cell assembly according to claim 16, wherein a plurality of third solder ribbons are provided, and at least one first solder ribbon and at least one second solder ribbon are disposed between two adjacent third solder ribbons.

18. The back-contact cell assembly according to claim 1, wherein a first soldering point is disposed at one end of the first cell close to the second cell, and the first soldering point is connected to the first solder ribbon.

19. The back-contact cell assembly according to claim 1, wherein the first busbar is disposed at an end portion of the second cell close to the first cell.

20. The back-contact cell assembly according to claim 1, wherein the back-contact cell assembly comprises at least two groups of cell strings arranged along the second direction, and the first insulating strip extends from one group of cell strings to another group of cell strings among the two groups of cell strings along the second direction.

21. A photovoltaic system, comprising the back-contact cell assembly according to any one of claims 1-20.
